# EUROPEAN PATENT APPLICATION

(11) **EP 4 768 994 A1**
(43) Date of publication of application: **01.07.2026**
(21) Application number: 24877084.4
(22) Date of filing: 03.10.2024
(51) Int. Cl.: G01T 1/24

(54) **RADIATION DETECTION ELEMENT MANUFACTURING METHOD, RADIATION DETECTION ELEMENT, AND RADIATION DETECTOR**

(30) Priority: 11.10.2023 JP 2023176135
(71) Applicant: HORIBA, Ltd., Minami-ku Kyoto-shi Kyoto 601-8510 (JP)
(72) Inventor: ISHIKURA, Koji, Kyoto-shi, Kyoto 601-8510 (JP)
(74) Representative: Isarpatent
(86) International application number: PCT/JP2024/035360
(87) International publication number: WO 2025/079486

(57) **Abstract**

Provided are a method for manufacturing a radiation detection element, a radiation detection element, and a radiation detector make it possible to detect low-energy radiation with high accuracy.

The method for manufacturing a radiation detection element includes: forming an oxide layer made of a semiconductor oxide on a first semiconductor layer; forming a second semiconductor layer on the oxide layer; and implanting ions of a dopant, which is for changing the semiconductor forming the first semiconductor layer into a different type of semiconductor, into the first semiconductor layer through the second semiconductor layer and the oxide layer to form a doping layer made of a semiconductor doped with the dopant between the first semiconductor layer and the oxide layer.

## Description

### Technical Field

The present invention relates to a method for manufacturing a radiation detection element, a radiation detection element, and a radiation detector.

### Background Art

Some radiation detectors for detecting radiation such as X-rays include a radiation detection element using a semiconductor. A radiation detection element using a semiconductor includes a semiconductor layer, and a doping layer that is doped with a dopant and is made of a semiconductor of a different type from the semiconductor layer is provided on the incidence side where radiation is incident. A voltage is applied to the semiconductor layer through the doping layer, thereby generating an electric field inside the semiconductor layer. Charges are generated inside the semiconductor layer in response to the incidence of radiation, and the charges are collected according to the electric field. A signal corresponding to the amount of charge is output to detect the radiation. Patent Literature 1 discloses an example of a radiation detection element.

### Citation List

Patent Literature:

Patent Literature 1: Japanese Patent No. 6905825

### Summary

### Technical Problems

An oxide layer overlaps the doping layer of the radiation detection element, and a conductive layer, such as a metal layer overlaps the oxide layer. Radiation passes through the conductive and oxide layers to be incident on the semiconductor layer. When the energy of the radiation is low, the transmittance of the radiation transmitted through the oxide layer decreases, resulting in a reduction in radiation detection sensitivity. In addition, charges generated in the oxide layer by the radiation are accelerated by the electric field in the oxide layer, thereby forming defects at an interface between the doping layer and the oxide layer. Some of the charges generated by the radiation are lost due to the defects, and the amount of charge corresponding to the radiation decreases. Since the energy of the radiation is detected according to the amount of charge, a decrease in the amount of charge results in detection of radiation with low energy. These problems may be considered to be addressable by reducing the thickness of the oxide layer.

The doping layer of the radiation detection element is formed by implanting ions of a dopant into the semiconductor layer through the oxide layer. When the oxide layer is made thinner, if the acceleration voltage of implanted ions is the same, the ions are implanted more deeply, resulting in a thicker doping layer. When the doping layer is thick, the probability that charges generated by radiation incident on the semiconductor layer will be absorbed by the doping layer increases, and accordingly, the problem of the detection of radiation with low energy also occurs.

It is also conceivable to implant ions of the dopant into the semiconductor layer with the oxide layer kept thick and then thinning the oxide layer by etching. However, the ion implantation weakens the bonds of the oxide, making it difficult to adjust the etching rate. For this reason, it is difficult to adjust the thickness of the oxide layer. Thus, it is difficult to realize a radiation detection element for detecting low-energy radiation with high accuracy.

The present invention has been made in view of the above circumstances, and it is an object of the present invention to provide a method for manufacturing a radiation detection element, a radiation detection element, and a radiation detector that make it possible to detect low-energy radiation with high accuracy.

### Solution to Problems

A method for manufacturing a radiation detection element according to one aspect of the present invention is characterized by comprising: forming an oxide layer made of a semiconductor oxide on a first semiconductor layer; forming a second semiconductor layer on the oxide layer; and implanting ions of a dopant, which is for changing the semiconductor forming the first semiconductor layer into a different type of semiconductor, into the first semiconductor layer through the second semiconductor layer and the oxide layer to form a doping layer made of a semiconductor doped with the dopant between the first semiconductor layer and the oxide layer.

In one aspect of the present invention, an oxide layer is formed on a first semiconductor layer, a second semiconductor layer is formed on the oxide layer, and ions of the dopant are implanted into the first semiconductor layer through the second semiconductor layer and the oxide layer to form a doping layer. Since the ions of the dopant pass through the second semiconductor layer in addition to the oxide layer, the thickness of the doping layer can be made equal to that in the related art even if the thickness of the oxide layer is made smaller than that in the related art. By making the thickness of the doping layer equal to that in the related art, the problems of a reduction in radiation detection sensitivity and the detection of radiation with low energy due to the thickness of the doping layer are prevented. In addition, by making the thickness of the oxide layer smaller than that in the related art, the detection sensitivity for low-energy radiation is improved. Therefore, it becomes possible to detect low-energy radiation with high sensitivity and accuracy.

The method for manufacturing a radiation detection element according to one aspect of the present invention is characterized by further comprising: reducing a thickness of the second semiconductor layer after forming the doping layer.

In one aspect of the present invention, the thickness of the second semiconductor layer is reduced after the doping layer is formed. Since the probability that radiation will be absorbed by the second semiconductor layer when passing through the second semiconductor layer is reduced, the detection sensitivity for low-energy radiation is improved.

The method for manufacturing a radiation detection element according to one aspect of the present invention is characterized by further comprising: forming a conductive layer on the second semiconductor layer.

In one aspect of the present invention, a conductive layer is formed on the second semiconductor layer. By forming a conductive layer with a high light-shielding property on the second semiconductor layer, the amount of light that passes through the second semiconductor layer and the oxide layer is reduced, and the generation of noise due to light is reduced.

The method for manufacturing a radiation detection element according to one aspect of the present invention is characterized by further comprising: after forming the doping layer, removing the second semiconductor layer and forming a conductive layer on the oxide layer.

In one aspect of the invention, the second semiconductor layer is removed, and a conductive layer is formed on the oxide layer. Since the second semiconductor layer is not included in the radiation detection element, radiation can be easily incident on the first semiconductor layer of the radiation detection element, improving the detection sensitivity for low-energy radiation.

The method for manufacturing a radiation detection element according to one aspect of the present invention is characterized by further comprising: thermally oxidizing the first semiconductor layer to form the oxide layer; removing a part of the oxide layer; and thermally oxidizing the first semiconductor layer after removing the part of the oxide layer to re-form the oxide layer in the removed portion of the oxide layer.

In one aspect of the present invention, after an oxide layer is formed by thermal oxidation of the first semiconductor layer, a part of the oxide layer is removed, and an oxide layer is re-formed by thermal oxidation of the first semiconductor layer. By adjusting the time for thermal oxidation, an oxide layer having a desired thickness can be easily formed.

A radiation detection element according to one aspect of the present invention is characterized by comprising: a first semiconductor layer into which radiation to be detected enters; a doping layer that is provided on a surface of the first semiconductor layer on a side on which the radiation is incident and that is made of a semiconductor doped with a dopant for changing a semiconductor forming the first semiconductor layer into a different type of semiconductor; an oxide layer provided on the doping layer and made of a semiconductor oxide; and a second semiconductor layer provided on the oxide layer.

In one aspect of the present invention, a radiation detection element includes a first semiconductor layer, a doping layer provided on one surface of the first semiconductor layer, an oxide layer provided on the doping layer, and a second semiconductor layer provided on the oxide layer. When forming the doping layer, ions of the dopant can be implanted through the oxide layer and the second semiconductor layer. By allowing the ions of the dopant to pass through the second semiconductor layer in addition to the oxide layer, the thickness of the doping layer can be made equal to that in the related art even if the thickness of the oxide layer is made smaller than that in the related art. By making the thickness of the doping layer equal to that in the related art, the problems of a reduction in radiation detection sensitivity and the detection of radiation with low energy due to the thickness of the doping layer are prevented. In addition, by making the thickness of the oxide layer smaller than that in the related art, the detection sensitivity for low-energy radiation is improved. Therefore, it becomes possible to detect low-energy radiation with high sensitivity and accuracy.

In the radiation detection element according to one aspect of the present invention, it is characterized in that the semiconductor forming the first semiconductor layer is n-type, the dopant is boron, and the semiconductor forming the second semiconductor layer is p-type.

In one aspect of the present invention, the composition of the first semiconductor layer is an n-type semiconductor, and a doping layer is formed by doping boron. In addition, the composition of the second semiconductor layer is a p-type semiconductor. The compositions of the doping layer and the second semiconductor layer are the same type of semiconductor, and the second semiconductor layer can be used as an electrode for the doping layer. Since no electric field is generated between the second semiconductor layer and the doping layer, no electric field is generated within the oxide layer. Charges in the oxide layer are not accelerated by the electric field. For this reason, defects are not formed at the interface between the oxide layer and the doping layer due to the accelerated charges. Charges generated by radiation incident on the first semiconductor layer are not lost through defects. For this reason, the detection of radiation with low energy due to defects does not occur.

In the radiation detection element according to one aspect of the present invention, it is characterized in that the second semiconductor layer is made of polysilicon.

In one aspect of the present invention, the composition of the second semiconductor layer is polysilicon. Polysilicon enables the second semiconductor layer to be easily formed without causing adverse effects such as contamination in the manufacturing process of the radiation detection element.

The radiation detection element according to one aspect of the present invention is characterized by further comprising: a conductive layer provided on the second semiconductor layer.

In one aspect of the invention, the radiation detection element includes a conductive layer located on the second semiconductor layer. Since the conductive layer has a high light-shielding property, the amount of light that passes through the second semiconductor layer and the oxide layer to be incident on the doping layer or the first semiconductor layer is reduced. As a result, the generation of noise due to light is reduced.

A radiation detection element according to one aspect of the present invention is characterized by comprising: a first semiconductor layer into which radiation to be detected enters; a doping layer that is provided on a surface of the first semiconductor layer on a side on which the radiation is incident and that is made of a semiconductor doped with a dopant for changing a semiconductor forming the first semiconductor layer into a different type of semiconductor; an oxide layer provided on the doping layer and made of a semiconductor oxide; and a conductive layer provided on the oxide layer, wherein a thickness of the oxide layer is less than 50 nm, and a concentration of the dopant contained in the doping layer is 1 × 1018 atoms/cm3 or less at a position where a depth from an interface between the oxide layer and the doping layer is 60 nm.

In one aspect of the present invention, the radiation detection element does not include a second semiconductor layer, but includes a conductive layer provided on the oxide layer. The thickness of the oxide layer is less than 50 nm, and the dopant concentration is 1 × 10¹⁸ atoms/cm³ or less at a position where the depth from the interface between the oxide layer and the doping layer is 60 nm. The thickness of the doping layer is equal to that in the related art, the problems of a reduction in radiation detection sensitivity and the detection of radiation with low energy due to the thickness of the doping layer are prevented. Since there is no second semiconductor layer and the thickness of the oxide layer is smaller than in the related art, radiation can be easily incident on the first semiconductor layer. As a result, the radiation detection sensitivity is improved.

The radiation detection element according to one aspect of the present invention is characterized by further comprising: a signal output electrode that is provided on a surface of the first semiconductor layer opposite to the surface on which the doping layer is provided and that outputs a signal in response to incidence of radiation; and a plurality of curved electrodes which are arranged at positions surrounding the signal output electrode and are located at different distances from the signal output electrode and to which voltages are applied so that potentials change according to the distances from the signal output electrode.

In one aspect of the present invention, the radiation detection element includes a signal output electrode provided on the rear side of the doping layer and a plurality of curved electrodes arranged at positions surrounding the signal output electrode. Voltages are applied to the curved electrodes so that potentials change according to the distances from the signal output electrode. As a result, the radiation detection element functions as a silicon drift type radiation detection element.

A radiation detector according to one aspect of the present invention is characterized by comprising: the radiation detection element according to any one of claims 6 to 11; a circuit board on which the radiation detection element is mounted; a collimator that shields a part of radiation before the radiation is incident on the radiation detection element; and a housing that accommodates the radiation detection element, the circuit board, and the collimator, wherein the housing has an unblocked opening, the radiation detection element is arranged so that an incidence surface on which radiation is incident faces the opening, and the collimator is arranged between the radiation detection element and the opening.

In one aspect of the present invention, the radiation detector includes a housing that accommodates the radiation detection element, and the housing has an opening that is not blocked by a window material. Since the opening is not blocked by a window material, low-energy radiation can be easily incident on the radiation detection element. That is, since low-energy radiation can be easily incident on the radiation detection element, the low-energy radiation is detected with high sensitivity in the radiation detection element.

### Advantageous Effects of Invention

According to the present invention, excellent effects are achieved, such as making it possible to detect low-energy radiation with high sensitivity and high accuracy.

### Brief Description of Drawings

FIG. 1 is a schematic cross-sectional view showing an example of a radiation detection element according to Embodiment 1.
FIG. 2 is a block diagram showing an example of the functional configuration of a radiation detection apparatus that uses a radiation detection element.
FIG. 3 is a schematic cross-sectional view showing an example of the configuration of a radiation detector including a radiation detection element.
FIG. 4 is a schematic cross-sectional view showing an example of a conventional radiation detection element.
FIG. 5 is a schematic cross-sectional view showing a part of a process for manufacturing a conventional radiation detection element.
FIG. 6A is a schematic cross-sectional view for explaining a method for manufacturing the radiation detection element according to Embodiment 1.
FIG. 6B is a schematic cross-sectional view for explaining a method for manufacturing the radiation detection element according to Embodiment 1.
FIG. 6C is a schematic cross-sectional view for explaining a method for manufacturing the radiation detection element according to Embodiment 1.
FIG. 7A is a schematic cross-sectional view for explaining a method for manufacturing the radiation detection element according to Embodiment 1.
FIG. 7B is a schematic cross-sectional view for explaining a method for manufacturing the radiation detection element according to Embodiment 1.
FIG. 8 is a graph showing the transmittance of X-rays incident on a doping layer in the radiation detection element according to Embodiment 1.
FIG. 9 is a schematic cross-sectional view showing an example of a radiation detection element according to Embodiment 2.
FIG. 10A is a schematic cross-sectional view for explaining a method for manufacturing a radiation detection element according to Embodiment 2.
FIG. 10B is a schematic cross-sectional view for explaining a method for manufacturing the radiation detection element according to Embodiment 2.
FIG. 11 is a schematic cross-sectional view showing an example of a radiation detection element including a conductive layer formed on a second semiconductor layer whose thickness has been reduced.
FIG. 12 is a graph showing the transmittance of X-rays incident on a doping layer in the radiation detection element according to Embodiment 2.
FIG. 13 is a schematic cross-sectional view showing an example of a radiation detection element according to Embodiment 3.
FIG. 14A is a schematic cross-sectional view for explaining a method for manufacturing the radiation detection element according to Embodiment 3.
FIG. 14B is a schematic cross-sectional view for explaining a method for manufacturing the radiation detection element according to Embodiment 3.
FIG. 14C is a schematic cross-sectional view for explaining a method for manufacturing the radiation detection element according to Embodiment 3.
FIG. 15 is a graph showing the transmittance of X-rays incident on a doping layer in the radiation detection element according to Embodiment 3.

### Description of Embodiments

Hereinafter, the present invention will be specifically described with reference to the diagrams showing embodiments thereof.

### <Embodiment 1>

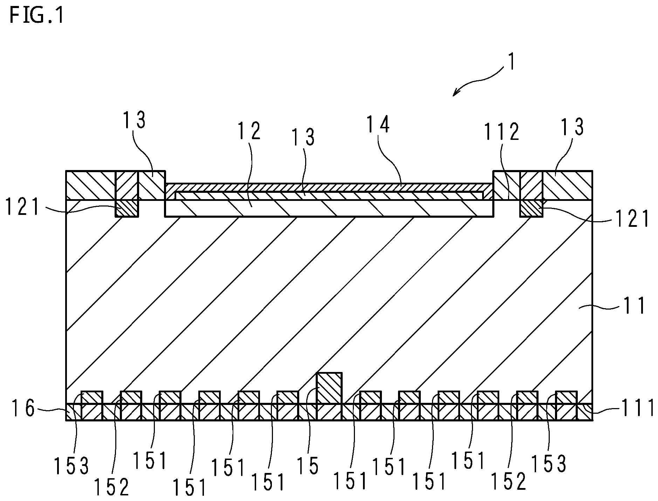

FIG. 1 is a schematic cross-sectional view showing an example of a radiation detection element 1 according to Embodiment 1. The radiation detection element 1 is a silicon drift type radiation detection element. The radiation detection element 1 has a flat plate shape overall. The radiation detection element 1 includes a first semiconductor layer 11 made of Si (silicon). The composition of the first semiconductor layer 11 is n-type Si. The first semiconductor layer 11 has a first surface 111 and a second surface 112 located on the back side of the first surface 111. The second surface 112 is a surface located on the incidence side on which radiation to be detected is incident.

A signal output electrode 15, which is an electrode to output a signal when radiation is detected, is provided at the center of the first surface 111. The composition of the signal output electrode 15 is Si, which is the same type as that of the first semiconductor layer 11. For example, the composition of the signal output electrode 15 is n+Si in which Si is doped with a specific dopant such as phosphorus. In addition, a plurality of curved electrodes 151 having a multiple ring shape are provided on the first surface 111. The composition of the curved electrode 151 is a semiconductor of a different type from that of the first semiconductor layer 11, and is p-type Si in which Si is doped with a specific dopant such as boron. For example, the composition of the curved electrode 151 is p+Si. The plurality of curved electrodes 151 arranged in a ring shape are almost concentric, and the signal output electrode 15 is located at almost the center of the plurality of curved electrodes 151. That is, the plurality of curved electrodes 151 surround the signal output electrode 15, and the distances between the signal output electrode 15 and the respective curved electrodes 151 are different.

Although four curved electrodes 151 are shown in FIG. 1, a larger number of curved electrodes 151 are provided in practice. In addition, the curved electrode 151 may have a shape obtained by deforming an annular shape, and the multiple curved electrodes 151 do not necessarily have to be concentric. In addition, the signal output electrode 15 may be arranged at a position other than the center of the multiple curved electrodes 151, or may be arranged at a position other than the center of the first surface 111.

An annular guard electrode 152 is provided outside the plurality of curved electrodes 151, and an annular ground electrode 153 is provided outside the guard electrode 152. The ground electrode 153 is connected to a ground potential. The potential of the guard electrode 152 is a floating potential. The guard electrode 152 prevents dielectric breakdown between the curved electrode 151 and the ground electrode 153. Although a single guard electrode 152 is shown in FIG. 1, a plurality of guard electrodes 152 arranged in multiple rings are provided in practice.

The first surface 111 is covered with an oxide layer 16 made of an Si oxide. The signal output electrode 15, the curved electrode 151, the guard electrode 152 and the ground electrode 153 are connected to electrodes passing through the oxide layer 16. The oxide layer 16 and the electrodes may be covered with an insulating film (not shown) made of an Si oxide or an Si nitride.

On the second surface 112, a doping layer 12 made of a semiconductor doped with a dopant for changing Si into a semiconductor of a different type from the composition of the first semiconductor layer 11 is formed. The composition of the doping layer 12 is p-type Si in which Si is doped with a specific dopant such as boron, for example, p+Si. The doping layer 12 is formed by doping a part of the first semiconductor layer 11 with a dopant. The doping layer 12 functions as an electrode to which a voltage is applied. The doping layer 12 includes a portion of the second surface 112 including the center of the second surface 112. The second surface 112 is an incidence surface located at a position where radiation to be detected by the radiation detection element 1 is incident, and the portion where the doping layer 12 is provided is an incidence region where the radiation is incident. The incident region includes most of the region of the second surface 112 including the center of the second surface 112.

The second surface 112 has a portion where the doping layer 12 is not formed, and an annular guard electrode 121 is provided outside the doping layer 12. The potential of the guard electrode 121 is a floating potential. Although a single guard electrode 121 is shown in FIG. 1, a plurality of guard electrodes 121 arranged in multiple rings are provided in practice. The guard electrode 121 prevents dielectric breakdown between the edge of the first semiconductor layer 11 and the doping layer 12. In addition, the radiation detection element 1 may be configured not to include the ground electrode 153 on the first surface 111 side but include the ground electrode on the second surface 112 side. That is, the ground electrode 153 may not be provided, and a ground electrode may be provided outside the guard electrode 121. In this configuration, the guard electrode 121 prevents dielectric breakdown between the doping layer 12 and the ground electrode. The radiation detection element 1 may be configured to include ground electrodes on both the first surface 111 side and the second surface 112 side.

The second surface 112 is covered with an oxide layer 13 made of an Si oxide. That is, the oxide layer 13 is provided on the doping layer 12. In the present embodiment, the radiation incidence side is the upper side. The guard electrode 121 is connected to an electrode passing through the oxide layer 13. A second semiconductor layer 14 is provided on a portion of the oxide layer 13 that covers the doping layer 12. Therefore, the portion of the oxide layer 13 that covers the doping layer 12 is covered with the second semiconductor layer 14. The composition of the second semiconductor layer 14 is a semiconductor of the same type as the composition of the doping layer 12, and the semiconductor is polysilicon. That is, the composition of the second semiconductor layer 14 is p-type polysilicon. The second semiconductor layer 14 passes through a part of the oxide layer 13 and is connected to the doping layer 12. Since the second semiconductor layer 14 has conductivity, the second semiconductor layer 14 also functions as an electrode for the doping layer 12. In Embodiment 1, no metal conductive layer is provided on the second semiconductor layer 14.

Voltages are applied to the plurality of curved electrodes 151 so that the potential of the innermost curved electrode 151 is the highest and the potential of the outermost curved electrode 151 is the lowest. In addition, the radiation detection element 1 is configured so that a predetermined electrical resistance is generated between the adjacent curved electrodes 151 that are at different distances from the signal output electrode 15. For example, by adjusting the composition of a portion located between the adjacent curved electrodes 151, an electrical resistance channel connecting the two curved electrodes 151 is formed. That is, the plurality of curved electrodes 151 are connected in a daisy chain manner through the electrical resistance. Due to the application of a voltage, each curved electrode 151 has a potential that monotonically increases sequentially from the outer curved electrode 151 toward the inner curved electrode 151. That is, the potential of the curved electrode 151 increases sequentially from the curved electrode 151 farther from the signal output electrode 15 to the curved electrode 151 closer to the signal output electrode 15. In addition, the plurality of curved electrodes 151 may include a pair of adjacent curved electrodes 151 having the same potential.

Due to the potentials of the plurality of curved electrodes 151, an electric field (potential gradient) is generated within the first semiconductor layer 11 such that, in a stepwise manner, the potential increases as the distance from the signal output electrode 15 decreases and decreases as the distance from the signal output electrode 15 increases. In addition, a voltage is applied to the doping layer 12 so that the potential of the doping layer 12 is a potential between the potential of the innermost curved electrode 151 and the potential of the outermost curved electrode 151. In this manner, an electric field is generated inside the first semiconductor layer 11 such that the potential increases as the distance from the signal output electrode 15 decreases.

Radiation such as X-rays, photons in general (including visible light, ultraviolet light, and infrared light), electron beams, or other charged particle beams is incident on the radiation detection element 1. The radiation is mainly incident on the first semiconductor layer 11 through the second surface 112. Charges in an amount corresponding to the energy of the radiation absorbed in the first semiconductor layer 11 are generated within the first semiconductor layer 11. The generated charges are electrons and holes. The generated charges move due to the electric field inside the first semiconductor layer 11, and one type of charge is concentrated and flows into the signal output electrode 15. In the present embodiment, electrons generated by the incidence of radiation move and flow into the signal output electrode 15. The signal output electrode 15 outputs a current signal corresponding to the amount of charges that have flowed thereinto. The action of the electric field enables highly sensitive radiation detection.

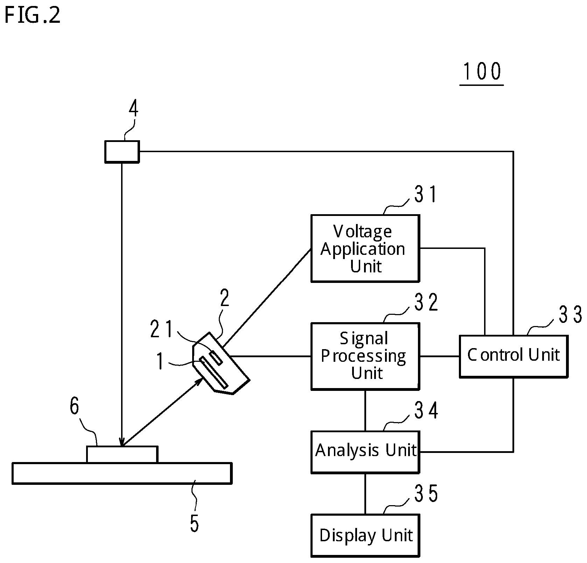

FIG. 2 is a block diagram showing an example of the functional configuration of a radiation detection apparatus 100 that uses the radiation detection element 1. The radiation detection apparatus 100 is, for example, an X-ray fluorescence analyzer. The radiation detection apparatus 100 includes an irradiation unit 4 that irradiates a sample 6 with radiation such as an electron beam or X-rays, a sample stage 5 on which the sample 6 is placed, and a radiation detector 2. The radiation detector 2 includes the radiation detection element 1 and a preamplifier 21. The preamplifier 21 is connected to the signal output electrode 15 of the radiation detection element 1. The signal output from the signal output electrode 15 is input to the preamplifier 21. The preamplifier 21 converts the current signal into a voltage signal. Since the value of the current signal is a value corresponding to the amount of charge that has flowed into the signal output electrode 15 and the amount of charge is a value corresponding to the energy of the radiation, the preamplifier 21 outputs a signal with an intensity corresponding to the energy of the radiation. In addition, a part of the preamplifier 21 may be included inside the radiation detector 2 and the other part may be arranged outside the radiation detector 2.

Radiation is emitted from the irradiation unit 4 to the sample 6, radiation such as fluorescent X-rays is generated in the sample 6, and the radiation detector 2 detects the radiation generated from the sample 6. In FIG. 2, the radiation is indicated by arrows. The radiation detector 2 outputs a signal proportional to the energy of the detected radiation. In addition, the radiation detection apparatus 100 may be configured to hold the sample 6 using a method other than placing the sample 6 on the sample stage 5.

A voltage application unit 31 and a signal processing unit 32 that processes the output signal are connected to the radiation detector 2. The voltage application unit 31 is connected to the radiation detection element 1. The voltage application unit 31 applies a voltage to the curved electrode 151 and the doping layer 12. The signal processing unit 32 is connected to the preamplifier 21. Due to the output of a signal from the preamplifier 21, the radiation detector 2 outputs a signal with an intensity corresponding to the energy of the radiation. The signal processing unit 32 is connected to an analysis unit 34. The analysis unit 34 is configured to include a calculation unit that performs a calculation and a memory that stores data. The voltage application unit 31, the signal processing unit 32, the analysis unit 34 and the irradiation unit 4 are connected to a control unit 33. The control unit 33 controls the operations of the voltage application unit 31, the signal processing unit 32, the analysis unit 34 and the irradiation unit 4.

The signal processing unit 32 receives the signal output from the radiation detector 2 and detects the intensity of the signal, thereby detecting a signal value corresponding to the energy of the radiation detected by the radiation detector 2. The signal processing unit 32 counts the signals for each signal value, and outputs data indicating the relationship between the signal value and the count number to the analysis unit 34.

The analysis unit 34 receives the data indicating the relationship between the signal value and the count number output from the signal processing unit 32. Based on the data from the signal processing unit 32, the analysis unit 34 generates a spectrum of the radiation incident on the radiation detector 2. Since the signal value corresponds to the energy of the radiation and the count number corresponds to the number of times the radiation is detected, the spectrum of the radiation can be obtained from the relationship between the signal value and the count number. The spectrum shows the relationship between the energy and intensity of the radiation. The process of counting the signals output from the radiation detector 2 for each signal value may be performed by the analysis unit 34 instead of the signal processing unit 32. The generation of the spectrum of the radiation may be performed by the signal processing unit 32. The analysis unit 34 may further perform information processing based on the spectrum of the radiation. For example, the analysis unit 34 performs qualitative analysis or quantitative analysis of elements contained in the sample 6 based on the spectrum of characteristic X-rays from the sample 6.

The analysis unit 34 is connected to a display unit 35 such as a liquid crystal display. The display unit 35 displays the spectrum generated by the analysis unit 34 and the analysis results by the analysis unit 34. The control unit 33 may be configured to receive the user's operation and control each unit of the radiation detection apparatus 100 in accordance with the received operation. In addition, the control unit 33 and the analysis unit 34 may be configured by the same computer.

In the example shown in FIG. 2, a form is shown in which radiation is emitted to the sample 6 and radiation generated from the sample 6 is detected. However, the radiation detection apparatus 100 may be configured to detect radiation transmitted through the sample 6 or radiation reflected by the sample 6. The radiation detection apparatus 100 may be configured to scan the sample with radiation by changing the direction of the radiation. The radiation detection apparatus 100 may be configured not to include the irradiation unit 4, the sample stage 5, the analysis unit 34, or the display unit 35.

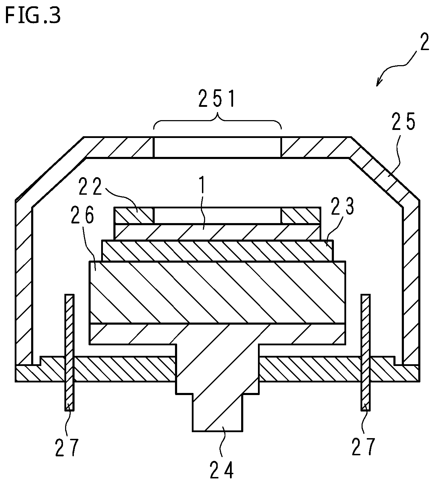

FIG. 3 is a schematic cross-sectional view showing an example of the configuration of the radiation detector 2 including the radiation detection element 1. The radiation detector 2 is an SDD (Silicon Drift Detector). The radiation detector 2 includes a housing 25 having a shape in which a truncated cone is connected to one end of a cylinder. The housing 25 is configured by covering a plate-shaped bottom plate portion with a cap-shaped cover. An opening 251 is formed at the front end of the housing 25. No window having a window material is provided at the opening 251, and the opening 251 is not blocked. Inside the housing 25, the radiation detection element 1, a collimator 22, a circuit board 23, a cooling unit 26, and a cold finger 24 are arranged. The housing 25 accommodates the radiation detection element 1, the collimator 22, the circuit board 23, and the cooling unit 26. The cooling unit 26 is, for example, a Peltier element.

The radiation detection element 1 is mounted on the surface of the circuit board 23 and is arranged at a position facing the opening 251. The radiation detection element 1 is arranged so that the first surface 111 faces the circuit board 23 and the second surface 112 faces the opening 251. The collimator 22 has a tubular shape with both ends open, and is formed of a material that shields radiation. The collimator 22 is arranged between the radiation detection element 1 and the opening 251. One end of the collimator 22 faces the opening 251, and the other end faces the surface of the radiation detection element 1. Radiation is incident on the inside of the housing 25 mainly through the opening 251, and the collimator 22 shields a part of the radiation before the radiation is incident on the radiation detection element 1. A portion of the second surface 112 other than the incidence region where the doping layer 12 is present is covered by the collimator 22 that shields radiation, and accordingly, no radiation is incident thereon. Since the incidence region is not covered by the collimator 22, radiation is incident thereon. The radiation detection element 1 detects radiation that is incident without being shielded by the collimator 22.

A circuit is formed on the circuit board 23, and the preamplifier 21 is mounted on the surface thereof. In FIG. 3, the preamplifier 21 is omitted. The back surface of the circuit board 23 is in thermal contact with a heat absorbing portion of the cooling unit 26 directly or through an intervening member. A heat dissipating portion of the cooling unit 26 is in thermal contact with the cold finger 24. The cold finger 24 has a flat-plate-shaped portion with which the heat dissipating portion of the cooling unit 26 is in thermal contact, and a portion passing through the bottom plate portion of the housing 25. The heat of the radiation detection element 1 is absorbed by the cooling unit 26 through the circuit board 23, transferred from the cooling unit 26 to the cold finger 24, and dissipated to the outside of the radiation detector 2 through the cold finger 24.

The radiation detector 2 includes a plurality of lead pins 27 passing through the bottom plate portion of the housing 25. The lead pins 27 are connected to the circuit board 23 using a method such as wire bonding. The application of a voltage to the radiation detection element 1 by the voltage application unit 31 and the output of a signal from the preamplifier 21 are performed through the lead pins 27. In addition, the radiation detector 2 may further include other components. Alternatively, the radiation detector 2 may be configured not to include the cooling unit 26 and the cold finger 24.

In the present embodiment, radiation that has mainly passed through the opening 251 is incident on the radiation detection element 1 and detected. Since the opening 251 is not blocked by a window material, radiation that cannot pass through the window material due to its low energy can also be incident on the radiation detection element 1. Therefore, the radiation detection apparatus 100 can detect radiation that cannot pass through a window material due to its low energy. For example, by detecting fluorescent X-rays with low energy, it is possible to detect elements with low fluorescent X-ray energy.

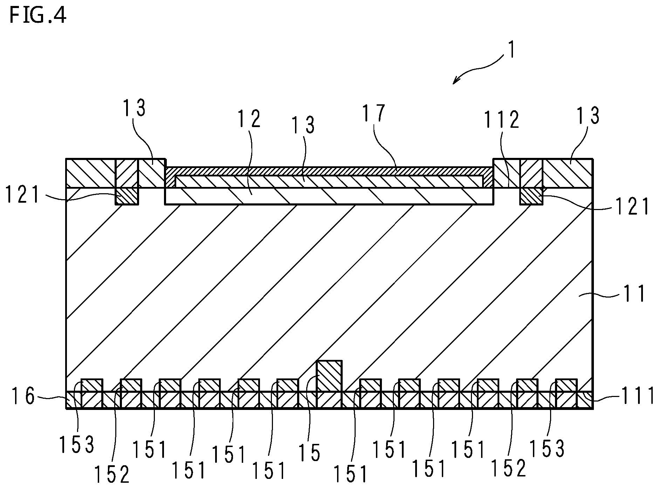

FIG. 4 is a schematic cross-sectional view showing an example of a conventional radiation detection element. In the conventional radiation detection element, a portion of the oxide layer 13 that covers the doping layer 12 is covered with a conductive layer 17 made of a conductive material. For example, the conductive layer 17 is a metal layer, and the composition of the conductive layer 17 is Al (aluminum). The conductive layer 17 passes through a part of the oxide layer 13 to be connected to the doping layer 12. The conductive layer 17 serves as an electrode for the doping layer 12.

In a conventional radiation detection element, radiation passes through the conductive layer 17 and the oxide layer 13 to be incident on the doping layer 12 and the first semiconductor layer 11. When the energy of the radiation is low, the radiation is absorbed because the radiation cannot pass through the oxide layer 13. Therefore, since the radiation is not incident on the first semiconductor layer 11, radiation detection sensitivity is reduced. When the radiation is absorbed by the oxide layer 13, charges are generated within the oxide layer 13. There is a difference between the work function of the metal forming the conductive layer 17 and the work function of the semiconductor forming the doping layer 12. Due to this difference, an electric field is generated between the conductive layer 17 and the doping layer 12, that is, within the oxide layer 13. For example, the work function of Al is 4 eV, and the work function of p+Si is 5 eV.

Some of the charges generated in the oxide layer 13 are accelerated by the electric field in the oxide layer 13, thereby forming defects at the interface between the oxide layer 13 and the doping layer 12. For example, generated holes are accelerated toward the doping layer 12, and penetrate into the doping layer 12, breaking the lattice bonds near the interface and generating defects. For example, defects (recombination centers) having negative charges are generated on the doping layer 12 side of the interface, and defects having positive charges are generated on the oxide layer 13 side.

Some of the charges generated by the radiation incident on the first semiconductor layer 11 are lost through defects at the interface between the oxide layer 13 and the doping layer 12. For example, the generated electrons combine with holes through recombination centers to be lost. As a result, the amount of charge flowing into the signal output electrode 15 in response to the incidence of the radiation is reduced. Since the energy of radiation is determined according to the amount of charge, a decrease in the amount of charge results in detection of radiation with low energy. In the spectrum of the radiation, the intensity of the peak decreases and tailing characteristic failures occur in which the intensity of the tail portion on the lower energy side than the peak increases.

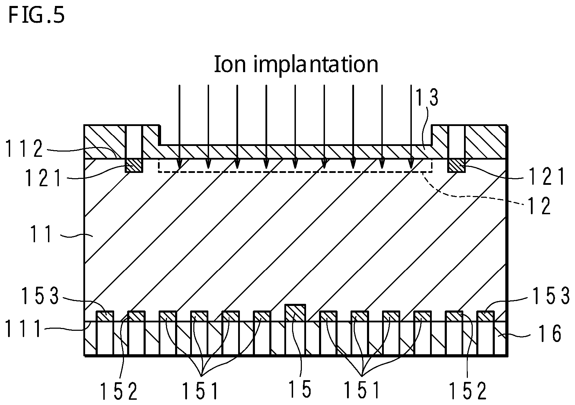

It is conceivable that the reduction in radiation detection sensitivity and the tailing characteristic failures are reduced by thinning the oxide layer 13. However, simply thinning the oxide layer 13 does not solve the problem. FIG. 5 is a schematic cross-sectional view showing a part of the process for manufacturing a conventional radiation detection element. Before the conductive layer 17 is formed after the oxide layer 13 is formed, ions are implanted into the first semiconductor layer 11 through the oxide layer 13. The trajectories of the ions are indicated by arrows. The implanted ions are ions of a dopant for making Si p-type, for example, boron ions. The ions of the dopant pass through the oxide layer 13 to be implanted into the first semiconductor layer 11. By implanting the ions, a part of the first semiconductor layer 11 is doped with the dopant, hereby forming the doping layer 12.

When the oxide layer 13 is thin, the ions of the dopant reach deeper positions in the first semiconductor layer 11 during ion implantation, making the doping layer 12 thicker. As the doping layer 12 becomes thicker, the probability that the charges generated by the radiation incident on the first semiconductor layer 11 will be lost increases. More specifically, as the doping layer 12 becomes thicker, the probability increases that electrons generated by radiation will penetrate into the doping layer 12 without moving to the signal output electrode 15, and the electrons penetrating into the doping layer 12 combine with holes in the doping layer 12 to be lost. For this reason, the amount of charge flowing into the signal output electrode 15 in response to the incidence of the radiation decreases. Therefore, a reduction in radiation detection sensitivity and tailing characteristic failures occur.

It is also conceivable to perform ion implantation with the oxide layer 13 kept thick and then thin the oxide layer 13 by etching. However, the ion implantation weakens the bonds of the oxide, making it difficult to adjust the etching rate. As a result, it is difficult to adjust the thickness of the oxide layer 13. For example, the thickness of the oxide layer 13 may become non-uniform, or the thickness of the oxide layer 13 may become unclear. It becomes necessary to check whether or not the thickness of the oxide layer 13 is at an appropriate value, which increases the cost.

In Embodiment 1, the thickness of the oxide layer 13 is smaller than that of the conventional oxide layer 13. In addition, as shown in FIG. 1, in Embodiment 1, the radiation detection element 1 includes the second semiconductor layer 14 located on a portion of the oxide layer 13 that covers the doping layer 12. In Embodiment 1, the total thickness of the oxide layer 13 and the second semiconductor layer 14 is equal to the thickness of the oxide layer 13 in the conventional radiation detection element.

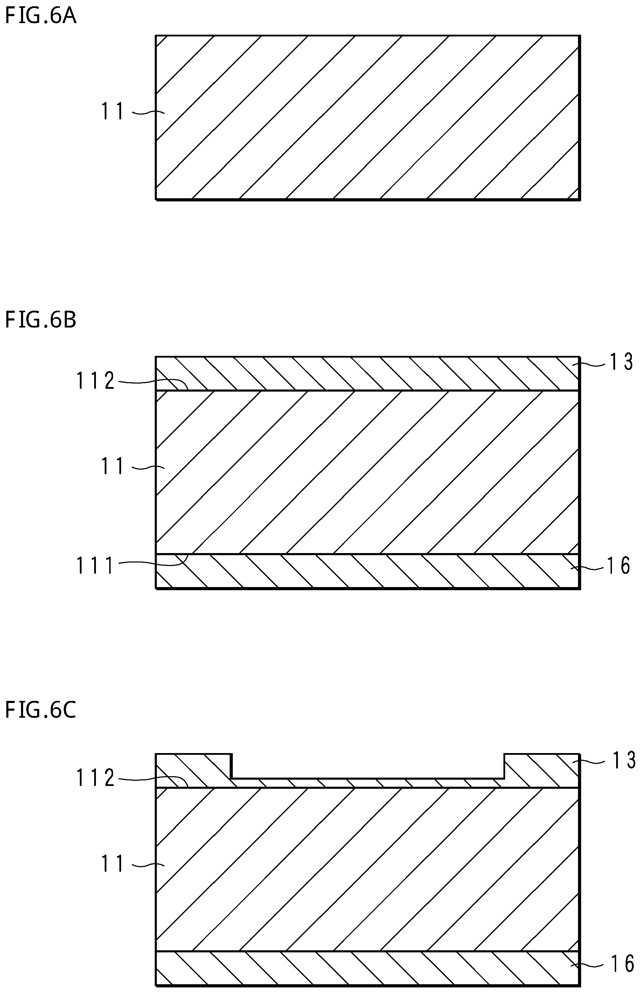

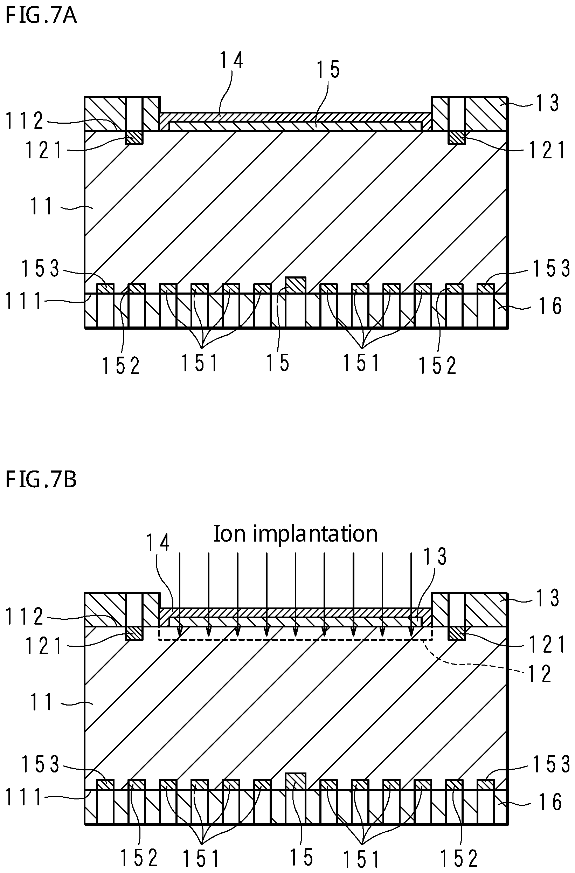

FIGS. 6A, 6B, 6C, 7A, and 7B are schematic cross-sectional views for explaining a method for manufacturing the radiation detection element 1 according to Embodiment 1. As shown in FIG. 6A, the radiation detection element 1 is manufactured from a plate-shaped semiconductor substrate. The semiconductor substrate is the first semiconductor layer 11. As shown in FIG. 6B, the oxide layer 16 covering the first surface 111 and the oxide layer 13 covering the second surface 112 are formed. The oxide layers 13 and 16 are formed by thermally oxidizing the first semiconductor layer 11. The first semiconductor layer 11 is gradually oxidized from its surface and a portion of the first semiconductor layer 11 becomes an oxide, thereby forming the oxide layers 13 and 16. By adjusting the time for thermal oxidation, the oxide layer 13 having a desired thickness can be easily formed.

As shown in FIG. 6C, at least a portion of the oxide layer 13 along the second surface 112 is partially etched in the thickness direction, thereby reducing the thickness of a part of the oxide layer 13. The portion of the oxide layer 13 whose thickness has been reduced is a portion located on the doping layer 12 to be formed. The thickness of the portion of the oxide layer 13 on the doping layer 12 is smaller than the thickness of the portion of the oxide layer 13 on the doping layer 12 in a conventional radiation detection element. In addition, the overall thickness of the oxide layer 13 may be reduced.

Alternatively, a portion of the oxide layer 13 along the second surface 112 may be removed by etching, and the first semiconductor layer 11 after the oxide layer 13 has been removed may be thermally oxidized, thereby re-forming the oxide layer 13 in a portion from which the oxide layer 13 was once removed. At this time, the thickness of the portion of the oxide layer 13 to be re-formed is made smaller than the other portions of the oxide layer 13. By adjusting the length of time for which the thermal oxidation of the first semiconductor layer 11 continues, the thickness of the portion of the oxide layer 13 to be re-formed can be adjusted to a predetermined thickness. In this manner, the thickness of a part of the oxide layer 13, that is, the thickness of a portion of the oxide layer 13 where the second semiconductor layer 14 is to be formed, can be reduced. In this method, the oxide layer 13 having a desired thickness can be easily obtained.

A portion of the oxide layer 13 at an appropriate position is removed by etching, and ions of a dopant are implanted into the first semiconductor layer 11 to form the guard electrode 121. In addition, a portion of the oxide layer 16 at an appropriate position is removed by etching, and ions of a dopant are implanted into the first semiconductor layer 11 to form the signal output electrode 15, the curved electrode 151, the guard electrode 152, and the ground electrode 153.

As shown in FIG. 7A, the second semiconductor layer 14 is formed on the portion of the oxide layer 13 whose thickness has been reduced. For example, the second semiconductor layer 14 is formed by vapor phase growth. By using polysilicon as the composition of the second semiconductor layer 14, the second semiconductor layer 14 can be easily formed without causing adverse effects such as contamination in the manufacturing process of the radiation detection element 1. The total thickness of the oxide layer 13 and the second semiconductor layer 14 is adjusted to be equal to the thickness of the oxide layer 13 in the conventional radiation detection element. For example, the oxide layer 13 has a thickness of 20 nm, and the second semiconductor layer 14 has a thickness of 60 nm.

In addition, as shown in FIG. 7B, ions are implanted into the first semiconductor layer 11 through the oxide layer 13 and the second semiconductor layer 14. For example, ion implantation is performed by making ions of a dopant the ions of the dopant accelerated by the voltage collide with the second semiconductor layer 14. The trajectories of the ions are indicated by arrows. The ions of the dopant pass through the second semiconductor layer 14 and the oxide layer 13 to be implanted into the first semiconductor layer 11. By implanting the ions of the dopant, the Si is doped with the dopants, thereby generating p-type Si. A portion of the first semiconductor layer 11 doped with the dopants becomes the doping layer 12. In this manner, the doping layer 12 is formed. The concentration of the dopant contained in the doping layer 12 is 1 × 10¹⁸ atoms/cm³ or less at a position where the depth from the interface between the oxide layer 13 and the doping layer 12 is 60 nm. Here, atoms indicates the number of dopant atoms, and atoms/cm³ is a unit of concentration and indicates the number of dopant atoms per cubic centimeter.

The total thickness of the oxide layer 13 and the second semiconductor layer 14 is equal to the thickness of the oxide layer 13 in the conventional radiation detection element. In addition, polysilicon and Si oxide have the same transmission ratio for ions of a dopant. For this reason, the depth to which the ions of the dopant reach inside the first semiconductor layer 11 during ion implantation is substantially the same as that in the conventional radiation detection element. Therefore, the thickness of the doping layer 12 is substantially the same as the thickness of the doping layer 12 in the conventional radiation detection element. After the doping layer 12 is formed, electrodes connected to the guard electrode 121, the signal output electrode 15, the curved electrode 151, the guard electrode 152, and the ground electrode 153 are formed, thereby completing the radiation detection element 1 as shown in FIG. 1.

In the radiation detection element 1 according to Embodiment 1, radiation to be detected passes through the oxide layer 13 and the second semiconductor layer 14 to be incident on the first semiconductor layer 11. The thickness of the oxide layer 13 is smaller than the thickness of the oxide layer 13 in the conventional radiation detection element. In addition, the total thickness of the oxide layer 13 and the second semiconductor layer 14 is equal to the thickness of the oxide layer 13 in the conventional radiation detection element. In the radiation detection element 1 according to Embodiment 1, since there is no conductive layer, the thickness of a material through which the radiation to be detected passes before being incident on the first semiconductor layer 11 is smaller than that in the related art. Since the rate at which radiation to be detected is absorbed before being incident on the first semiconductor layer 11 is reduced compared to the related art, the detection sensitivity for low-energy radiation is improved.

In the radiation detection element 1 according to Embodiment 1, since the thickness of the doping layer 12 is substantially the same as the thickness of the doping layer 12 in the conventional radiation detection element, the probability that electrons generated by radiation will penetrate into the doping layer 12 is almost the same as in the conventional radiation detection element. For this reason, the amount of charge flowing into the signal output electrode 15 in response to the incidence of radiation is not reduced compared to the related art due to the thickness of the doping layer 12. Therefore, a reduction in radiation detection sensitivity and tailing characteristic failures due to the thickness of the doping layer 12 do not occur.

In the radiation detection element 1 according to Embodiment 1, the second semiconductor layer 14 also functions as an electrode for the doping layer 12. The second semiconductor layer 14 and the doping layer 12 are formed of the same type of semiconductor, and there is no difference between the work function of the semiconductor forming the second semiconductor layer 14 and the work function of the semiconductor forming the doping layer 12. Therefore, no electric field is generated between the second semiconductor layer 14 and the doping layer 12. That is, no electric field is generated within the oxide layer 13. Even if radiation is absorbed in the oxide layer 13 to generate charges, the charges are not accelerated by the electric field. For this reason, defects are not formed at the interface between the oxide layer 13 and the doping layer 12 due to the accelerated charges. Since no defects are formed at the interface, the charges generated by the radiation incident on the first semiconductor layer 11 are not lost through the defects. The amount of charge flowing into the signal output electrode 15 in response to the incidence of radiation is not reduced due to defects formed at the interface. Tailing characteristic failures due to defects formed at the interface does not occur.

Even if a small voltage is generated in the oxide layer 13, the probability that radiation will be absorbed in the oxide layer 13 to generate charges is low because the oxide layer 13 is thin. In addition, since the oxide layer 13 is thin, the distance over which the charges are accelerated is short, and the charges are not significantly accelerated. For this reason, few defects are formed at the interface between the oxide layer 13 and the doping layer 12, and it is unlikely to occur that the amount of charge flowing into the signal output electrode 15 decreases due to such defects. Therefore, tailing characteristic failures due to defects formed at the interface is unlikely to occur. If the thickness of the oxide layer 13 is 50 nm or less, the same effects can be obtained.

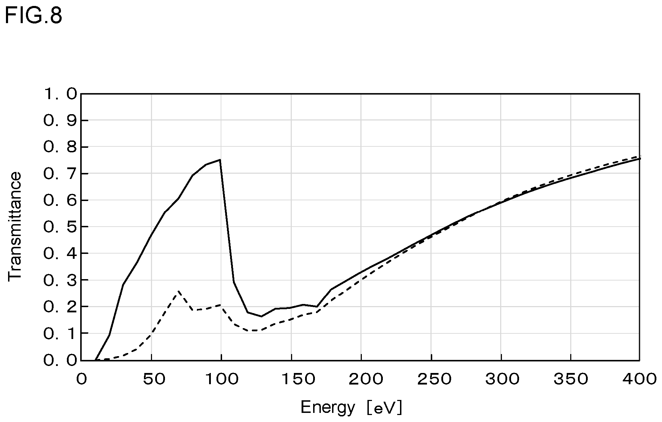

FIG. 8 is a graph showing the transmittance of X-rays incident on the doping layer 12 in the radiation detection element 1 according to Embodiment 1. In the diagram, the horizontal axis indicates the energy of X-rays, and the vertical axis indicates the transmittance of X-rays. The transmittance in a conventional radiation detection element is indicated by a broken line, and the transmittance in the radiation detection element 1 according to Embodiment 1 is indicated by a solid line. In the conventional radiation detection element whose transmittance is shown in FIG. 8, the thickness of the oxide layer is 80 nm, and the thickness of the conductive layer is 30 nm. In the radiation detection element 1 according to Embodiment 1 whose transmittance is shown in FIG. 8, the thickness of the oxide layer 13 is 20 nm, and the thickness of the second semiconductor layer 14 is 60 nm. For the conventional radiation detection element, the transmittance of X-rays transmitted through the oxide layer and the conductive layer is shown. For the radiation detection element 1 according to Embodiment 1, the transmittance of X-rays transmitted through the oxide layer 13 and the second semiconductor layer 14 is shown.

In the radiation detection element 1 according to Embodiment 1, in a low-energy region below 250 eV the transmittance of X-rays is higher than that in the related art. In particular, in a low-energy region below 100 eV, the transmittance of X-rays is significantly high. Thus, in Embodiment 1, the sensitivity for detecting low-energy radiation is improved. For example, the sensitivity for detecting characteristic X-rays of Be (beryllium) with an energy of 109 eV or characteristic X-rays of B (boron) with an energy of 183 eV is improved.

As described above in detail, in the radiation detection element 1 according to Embodiment 1, radiation detection sensitivity is improved, and in particular, the sensitivity for detecting low-energy radiation is improved. In addition, even when low-energy radiation is incident on the radiation detection element 1, tailing characteristic failures are unlikely to occur. For this reason, it becomes possible to accurately identify the energy of radiation even if the energy is low. Therefore, due to the radiation detection element 1 according to Embodiment 1, it is possible to detect low-energy radiation with high sensitivity and accuracy. In Embodiment 1, since the opening 251 is not blocked by a window material, low-energy radiation can be easily incident on the radiation detection element 1. That is, since the low-energy radiation is more likely to be incident on the radiation detection element 1, the low-energy radiation is detected with high sensitivity and accuracy in the radiation detection element 1. Therefore, by using the radiation detector 2 according to Embodiment 1, it is possible to reliably detect low-energy radiation with high sensitivity and accuracy.

### <Embodiment 2>

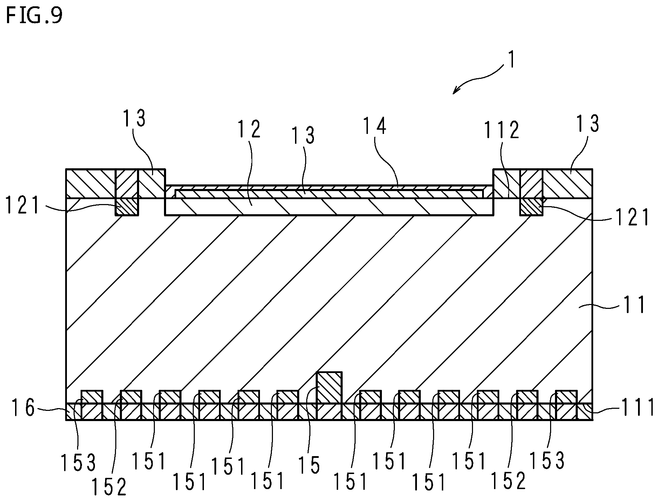

FIG. 9 is a schematic cross-sectional view showing an example of a radiation detection element 1 according to Embodiment 2. The configuration of a radiation detection apparatus 100 other than the radiation detection element 1 is the same as that in Embodiment 1. The thickness of the second semiconductor layer 14 in Embodiment 2 is smaller than the second semiconductor layer 14 in Embodiment 1. The configuration of the other portions of the radiation detection element 1 is the same as that in Embodiment 1.

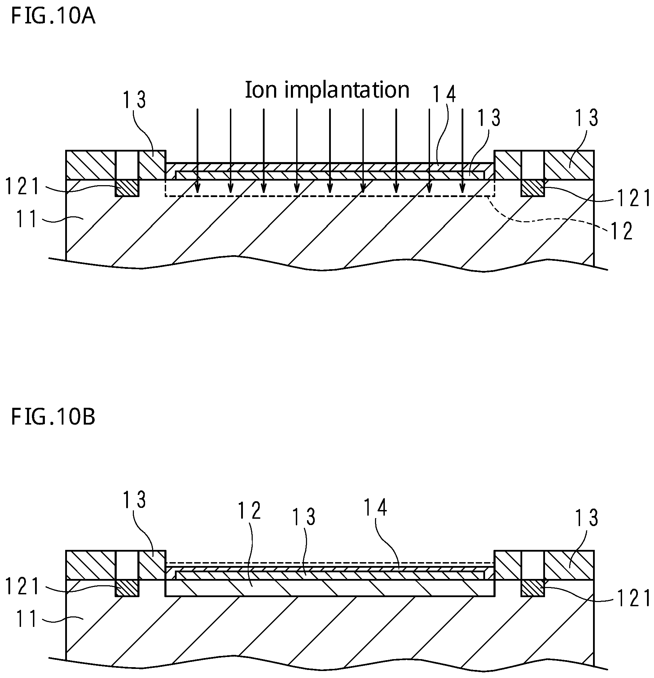

FIGS. 10A and 10B are schematic cross-sectional views for explaining a method for manufacturing the radiation detection element 1 according to Embodiment 2. As in Embodiment 1, an oxide layer 13 is formed, and a signal output electrode 15, a curved electrode 151, a guard electrode 152, and a ground electrode 153 are formed. As in Embodiment 1, the thickness of a portion of the oxide layer 13 on the doping layer 12 is smaller than the thickness of a portion of the oxide layer 13 on the doping layer 12 in a conventional radiation detection element. As in Embodiment 1, the second semiconductor layer 14 is formed on the oxide layer 13. At this point in time, the total thickness of the oxide layer 13 and the second semiconductor layer 14 is the same as that in Embodiment 1.

As shown in FIG. 10A, ions are implanted into the first semiconductor layer 11 through the oxide layer 13 and the second semiconductor layer 14, as in Embodiment 1. The trajectories of ions of a dopant are indicated by arrows. By the ion implantation, the doping layer 12 is formed. Since the total thickness of the oxide layer 13 and the second semiconductor layer 14 at the time of ion implantation is the same as that in Embodiment 1, the thickness of the doping layer 12 is the same as that in Embodiment 1. In Embodiment 2 as well, the concentration of the dopant contained in the doping layer 12 is 1 × 10¹⁸ atoms/cm³ or less at a position where the depth from the interface between the oxide layer 13 and the doping layer 12 is 60 nm.

As shown in FIG. 10B, after the ion implantation, the thickness of the second semiconductor layer 14 is reduced. In FIG. 10B, the surface of the second semiconductor layer 14 before the thickness is reduced is indicated by a broken line. For example, the thickness of the second semiconductor layer 14 is reduced by etching. After the thickness of the second semiconductor layer 14 is reduced, electrodes connected to the guard electrode 121, the signal output electrode 15, the curved electrode 151, the guard electrode 152, and the ground electrode 153 are formed, thereby completing the radiation detection element 1 as shown in FIG. 9. The second semiconductor layer 14 also functions as an electrode for the doping layer 12.

In Embodiment 2, since the thickness of the second semiconductor layer 14 is reduced after the ion implantation, the thickness of the second semiconductor layer 14 is smaller than that of the second semiconductor layer 14 in Embodiment 1. Therefore, the probability that radiation is absorbed by the second semiconductor layer 14 when passing through the second semiconductor layer 14 becomes lower. As a result, the detection sensitivity for low-energy radiation is improved. In Embodiment 2, the thickness of the second semiconductor layer 14 is less than 60 nm and 20 nm or more. For example, the thickness of the second semiconductor layer 14 is 20 nm. If the thickness of the second semiconductor layer 14 is less than 20 nm, the performance as an electrode is lowered.

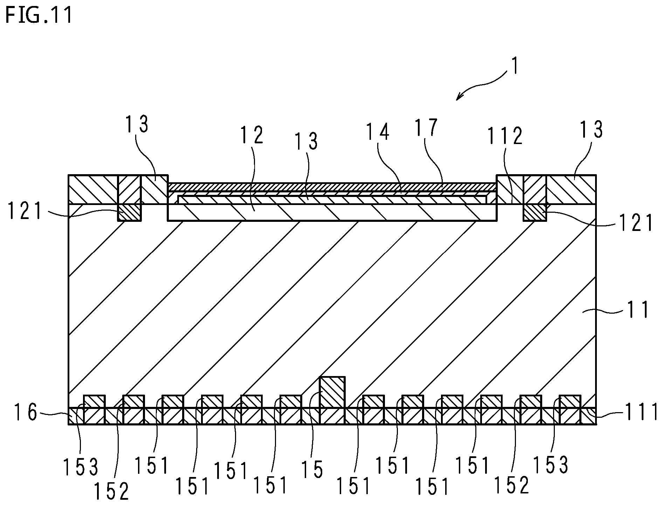

The method for manufacturing the radiation detection element 1 may be configured to form a conductive layer on the second semiconductor layer 14 with a reduced thickness. FIG. 11 is a schematic cross-sectional view showing an example of the radiation detection element 1 including a conductive layer 17 formed on the second semiconductor layer 14 with a reduced thickness. The radiation detection element 1 includes the conductive layer 17 provided on the second semiconductor layer 14. The conductive layer 17 covers the second semiconductor layer 14. For example, the composition of the conductive layer 17 is Au (gold). The composition of the conductive layer 17 may be Al, Be, or C (carbon). For example, the thickness of the conductive layer 17 is 10 nm. The conductive layer 17 also functions as an electrode for the doping layer 12.

In the method for manufacturing the radiation detection element 1 according to this form, after the process for reducing the thickness of the second semiconductor layer 14 shown in FIG. 10B, the conductive layer 17 is formed on the second semiconductor layer 14. For example, the conductive layer 17 is formed by sputtering. After the conductive layer 17 is formed, electrodes connected to the guard electrode 121, the signal output electrode 15, the curved electrode 151, the guard electrode 152, and the ground electrode 153 are formed, thereby completing the radiation detection element 1 as shown in FIG. 11.

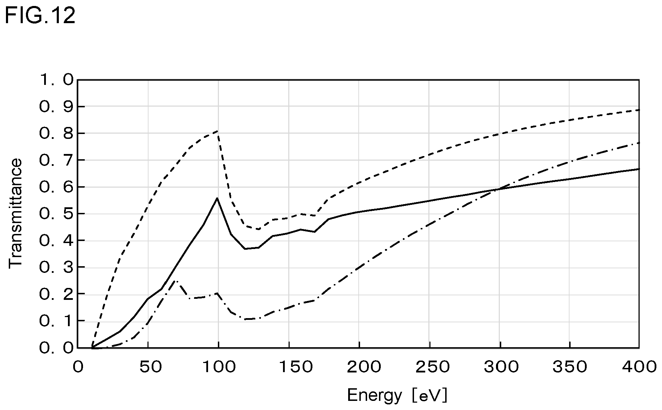

FIG. 12 is a graph showing the transmittance of X-rays incident on the doping layer 12 in the radiation detection element 1 according to Embodiment 2. In the diagram, the horizontal axis indicates the energy of X-rays, and the vertical axis indicates the transmittance of X-rays. The transmittance in a conventional radiation detection element is indicated by a one-dot chain line, the transmittance in the radiation detection element 1 that does not include the conductive layer 17 among the radiation detection elements 1 according to Embodiment 2 is indicated by a broken line, and the transmittance in the radiation detection element 1 that includes the conductive layer 17 among the radiation detection elements 1 according to Embodiment 2 is indicated by a solid line. For the radiation detection element 1 according to Embodiment 2, which does not include the conductive layer 17, the transmittance of X-rays transmitted through the oxide layer 13 and the second semiconductor layer 14 is shown. For the radiation detection element 1 including the conductive layer 17 according to Embodiment 2, the transmittance of X-rays transmitted through the oxide layer 13, the second semiconductor layer 14, and the conductive layer 17 is shown.

In the conventional radiation detection element whose transmittance is shown in FIG. 12, the thickness of the oxide layer is 80 nm, and the thickness of the conductive layer is 30 nm. The radiation detection element 1 according to Embodiment 2, whose transmittance is shown in FIG. 12, is obtained by performing ion implantation in a state the thickness of the oxide layer 13 is 20 nm and the thickness of the second semiconductor layer 14 is 60 nm and then reducing the thickness of the second semiconductor layer 14 to 20 nm. That is, ion implantation is performed in a state in which the total thickness of the oxide layer 13 and the second semiconductor layer 14 is equal to the thickness of the oxide layer in the conventional radiation detection element, and then the thickness of the second semiconductor layer 14 is reduced. In addition, the composition of the conductive layer 17 is Au, and the thickness of the conductive layer 17 is 10 nm.

In the radiation detection element 1 that does not include the conductive layer 17 among the radiation detection elements 1 according to Embodiment 2, the thickness of the second semiconductor layer 14 is smaller than that in Embodiment 1, and accordingly, the transmittance of X-rays is higher than that in Embodiment 1. In the radiation detection element 1 that includes the conductive layer 17 among the radiation detection elements 1 according to Embodiment 2, the number of layers through which X-rays pass before being incident on the doping layer 12 increases, and accordingly, the transmittance of X-rays is lower than that in the radiation detection element 1 that does not include the conductive layer 17.

In the radiation detection element 1 according to Embodiment 2, the transmittance of X-rays in the low-energy region below 250 eV is higher than that in the related art. For example, in the radiation detection element 1 that does not include the conductive layer 17, the transmittance of characteristic X-rays of Be having an energy of 109 eV is approximately 3.7 times that in the conventional radiation detection element, and the transmittance of characteristic X-rays of B having an energy of 183 eV is approximately twice that in the conventional radiation detection element. Thus, in Embodiment 2 as well, the sensitivity for detecting low-energy radiation is improved.

In Embodiment 2, since the thickness of the doping layer 12 is the same as that in Embodiment 1, a reduction in radiation detection sensitivity and tailing characteristic failures due to the thickness of the doping layer 12 do not occur. As in Embodiment 1, since there is no difference between the work function of the semiconductor forming the second semiconductor layer 14 and the work function of the semiconductor forming the doping layer 12, no electric field is generated in the oxide layer 13. As in Embodiment 1, defects are not formed at the interface between the oxide layer 13 and the doping layer 12 due to the influence of the electric field, and accordingly, tailing characteristic failures due to defects do not occur. Therefore, due to the radiation detection element 1, it is possible to detect low-energy radiation with high sensitivity and accuracy. In addition, by using the radiation detector 2, it is possible to reliably detect low-energy radiation with high sensitivity and accuracy.

The conductive layer 17 has a higher light-shielding property than the second semiconductor layer 14. In the radiation detection element 1 including the conductive layer 17, the conductive layer 17 covers the second semiconductor layer 14, and accordingly, compared to Embodiment 1, the amount of light that passes through the second semiconductor layer 14 and the oxide layer 13 to be incident on the doping layer 12 or the first semiconductor layer 11 is reduced. This reduces the generation of noise caused by light incident on the doping layer 12 or the first semiconductor layer 11. Therefore, in the radiation detection element 1 including the conductive layer 17, it is possible to detect radiation with higher accuracy.

### <Embodiment 3>

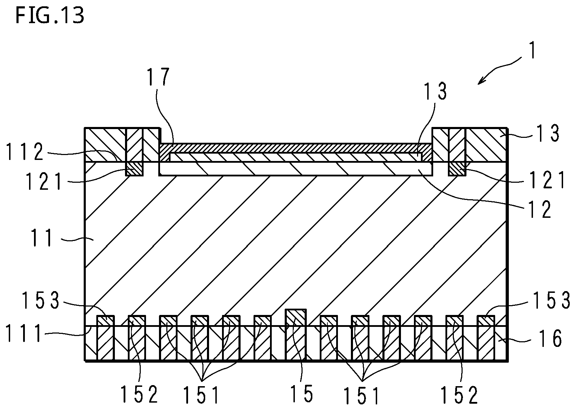

FIG. 13 is a schematic cross-sectional view showing an example of a radiation detection element 1 according to Embodiment 3. The configuration of a radiation detection apparatus 100 other than the radiation detection element 1 is the same as that in Embodiment 1. The radiation detection element 1 according to Embodiment 3 does not include the second semiconductor layer 14. The radiation detection element 1 includes an oxide layer 13 and a conductive layer 17 provided on the oxide layer 13. The conductive layer 17 covers the oxide layer 13.

The thickness of the oxide layer 13 is less than 50 nm and 10 nm or more. For example, the thickness of the oxide layer 13 is 20 nm. The composition of the conductive layer 17 is Au, Al, Be, or C. For example, the conductive layer 17 is made of Au, and the thickness of the conductive layer 17 in a portion overlapping the oxide layer 13 is 10 nm. When the composition of the conductive layer 17 is Al or Be, the thickness of the conductive layer 17 needs to be larger than the thickness of Au in order to maintain conductivity, because Al and Be oxidize. For example, the conductive layer 17 is made of Al, and the thickness of the conductive layer 17 in a portion overlapping the oxide layer 13 is 30 nm. In addition, the concentration of the dopant contained in the doping layer 12 is 1 × 10¹⁸ atoms/cm³ or less at a position where the depth from the interface between the oxide layer 13 and the doping layer 12 is 60 nm.

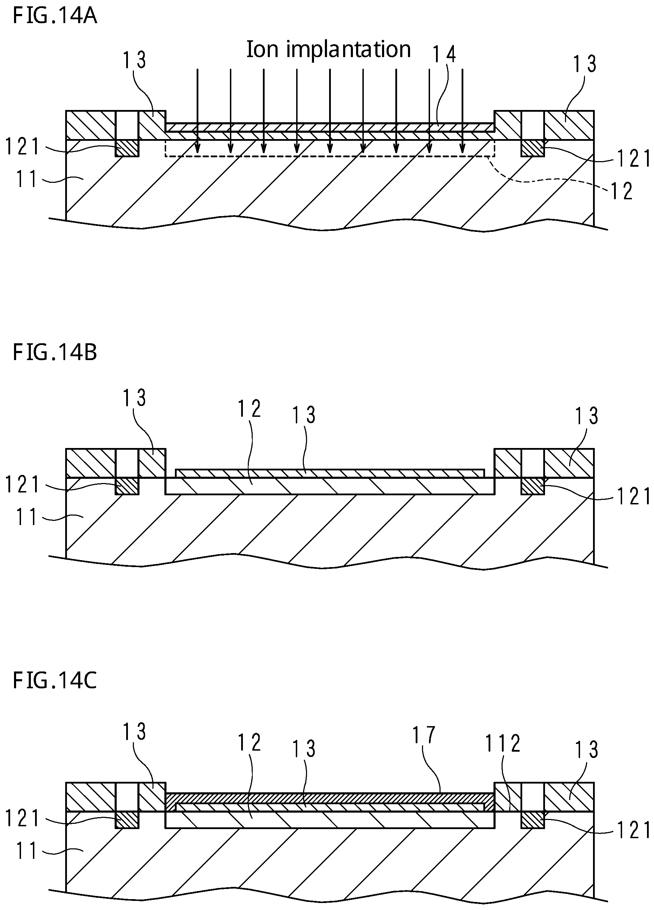

FIGS. 14A, 14B, and 14C are schematic cross-sectional views for explaining a method for manufacturing the radiation detection element 1 according to Embodiment 3. As in Embodiments 1 and 2, an oxide layer 13 is formed, a signal output electrode 15, a curved electrode 151, a guard electrode 152, and a ground electrode 153 are formed, and a second semiconductor layer 14 is formed. At this time, the second semiconductor layer 14 is formed so as not to come into contact with the first semiconductor layer 11. As shown in FIG. 14A, ions are implanted into the first semiconductor layer 11 through the oxide layer 13 and the second semiconductor layer 14, as in Embodiments 1 and 2. The trajectories of ions of the dopant are indicated by arrows. By the ion implantation, the doping layer 12 is formed. The thicknesses of the oxide layer 13 and the second semiconductor layer 14 are adjusted so that the concentration of the dopant is 1 × 10¹⁸ atoms/cm³ or less at a position where the depth from the interface between the oxide layer 13 and the doping layer 12 is 60 nm.

After the doping layer 12 is formed by the ion implantation, the second semiconductor layer 14 is removed as shown in FIG. 14B. For example, the second semiconductor layer 14 is removed by dry etching or wet etching. In addition, as shown in FIG. 14B, a portion of the oxide layer 13 is opened. Then, as shown in FIG. 14C, a conductive layer 17 is formed on the oxide layer 13. For example, the conductive layer 17 is formed by sputtering. After the conductive layer 17 is formed, electrodes connected to the guard electrode 121, the signal output electrode 15, the curved electrode 151, the guard electrode 152, and the ground electrode 153 are formed.

The conductive layer 17 stabilizes the surface potential of the oxide layer 13. The conductive layer 17 functions as an electrode for the doping layer 12 and also has a light-shielding property. Since the conductive layer 17 has a light-shielding property, the amount of light that passes through the oxide layer 13 to be incident on the doping layer 12 or the first semiconductor layer 11 is reduced. Therefore, since the generation of noise due to light incident on the doping layer 12 or the first semiconductor layer 11 is reduced, the accuracy of radiation detection is improved.

In a conventional radiation detection element that does not use a second semiconductor layer during manufacturing, tailing characteristic failures occur when the thickness of the oxide layer is less than 50 nm. The concentration of the dopant contained in the conventional radiation detection element was measured by SIMS (Secondary Ion Mass Spectrometry). In a conventional radiation detection element with an oxide layer thickness of 50 nm, the measurement results showed that the dopant concentration was 1 × 10¹⁸ atoms/cm³ at a position where the depth from the interface between the oxide layer and the doping layer was 60 nm. When the thickness of the oxide layer is further reduced in a conventional radiation detection apparatus, the dopant concentration becomes higher. That is, when the thickness of the oxide layer is less than 50 nm in a conventional radiation detection apparatus, the dopant concentration exceeds 1 × 10¹⁸ atoms/cm³ at a position where the depth from the interface between the oxide layer and the doping layer is 60 nm. Since tailing characteristic failures occur when the thickness of the oxide layer is less than 50 nm in a conventional radiation detection apparatus, the tailing characteristic failures occur if the dopant concentration exceeds 1 × 10¹⁸ atoms/cm³ at a position where the depth from the interface is 60 nm. Conversely, if the dopant concentration is 1 × 10¹⁸ atoms/cm³ or less at a position where the depth from the interface is 60 nm, tailing characteristic failures do not occur.

In Embodiment 3, by using a manufacturing method using the second semiconductor layer 14, it was possible to keep the dopant concentration at 1 × 10¹⁸ atoms/cm³ or less at a position where the depth from the interface between the oxide layer 13 and the doping layer 12 was 60 nm while the thickness of the oxide layer 13 is less than 50 nm. A portion where the dopant concentration exceeds 1 × 10¹⁸ atoms/cm³ is at a position where the depth from the interface is less than 60 nm. Therefore, the thickness of the doping layer 12 is equal to that in the related art. Since the thickness of the doping layer 12 is equal to that in the related art, a reduction in radiation detection sensitivity and tailing characteristic failures due to the thickness of the doping layer 12 do not occur. While preventing the occurrence of tailing characteristic failures, the thickness of the oxide layer 13 is smaller than the thickness of the oxide layer in a conventional radiation detection element. Since there is no second semiconductor layer 14 and the thickness of the oxide layer 13 is smaller than that in the related art, radiation can be easily incident on the first semiconductor layer 11. As a result, radiation detection sensitivity is improved. In particular, since low-energy radiation can be more easily incident on the first semiconductor layer 11, it is possible to detect low-energy radiation with higher sensitivity and accuracy.

When the thickness of the oxide layer 13 is less than 10 nm, it becomes difficult to form the oxide layer 13 with a stable thickness. For example, there is a possibility that holes may be formed in the oxide layer 13. For this reason, the thickness of the oxide layer 13 is 10 nm or more. Preferably, the thickness of the oxide layer 13 is 10 nm or more and 20 nm or less.

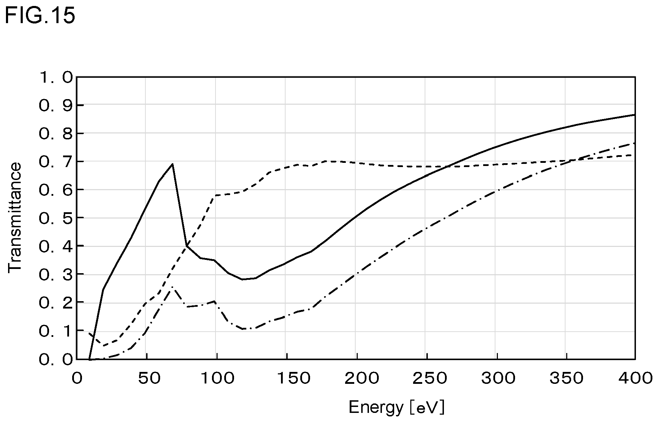

FIG. 15 is a graph showing the transmittance of X-rays incident on the doping layer 12 in the radiation detection element 1 according to Embodiment 3. In the diagram, the horizontal axis indicates the energy of X-rays, and the vertical axis indicates the transmittance of X-rays. The transmittance is the transmittance of X-rays that have passed through the conductive layer 17 and the oxide layer 13. The transmittance in a conventional radiation detection element is indicated by a one-dot chain line. In the conventional radiation detection element, the thickness of the oxide layer is 80 nm, the thickness of the composition of the conductive layer is Al, and the thickness of the conductive layer is 30 nm. The transmittance in the radiation detection element 1 in which the composition of the conductive layer 17 is Al, among the radiation detection elements 1 according to Embodiment 3, is indicated by a solid line. In this radiation detection element 1, the thickness of the oxide layer 13 is 20 nm, and the thickness of the conductive layer 17 made of Al is 30 nm. The transmittance in the radiation detection element 1 in which the composition of the conductive layer 17 is Au, among the radiation detection elements 1 according to Embodiment 3, is indicated by a broken line. In this radiation detection element 1, the thickness of the oxide layer 13 is 20 nm, and the thickness of the conductive layer 17 made of Al is 10 nm.

In the radiation detection element 1 according to Embodiment 3, in all cases, the transmittance of X-rays in a low-energy region below 250 eV is higher than that in the related art. For example, in the radiation detection element 1 in which the composition of the conductive layer 17 is Au and the thickness of the conductive layer 17 is 10 nm, the transmittance of characteristic X-rays of Be is approximately 3.9 times that in the conventional radiation detection element, and the transmittance of characteristic X-rays of B is approximately 2.4 times that in the conventional radiation detection element. Thus, in Embodiment 3 as well, the sensitivity for detecting low-energy radiation is improved.

The radiation detection elements 1 according to Embodiments 1 to 3 may have a configuration in which another layer is present between the first semiconductor layer 11 and the doping layer 12. The radiation detection element 1 may have a configuration in which another layer is present between the doping layer 12 and the oxide layer 13, or may have a configuration in which another layer is present between the oxide layer 13 and the second semiconductor layer 14. The radiation detection element 1 according to Embodiment 1 may have a configuration in which another layer is present on the second semiconductor layer 14. The radiation detection element 1 according to Embodiment 2 may have a configuration in which another layer is present between the second semiconductor layer 14 and the conductive layer 17, or may have a configuration in which another layer is present on the conductive layer 17. The radiation detection element 1 according to Embodiment 3 may have a configuration in which another layer is present between the oxide layer 13 and the conductive layer 17.

In Embodiments 1 to 3, a configuration has been described in which the radiation detection element 1 has one set of a signal output electrode 15 and a plurality of curved electrodes 151. However, the radiation detection element 1 may have a configuration including a plurality of sets of a signal output electrode 15 and a plurality of curved electrodes 151. In Embodiments 1 to 3, a configuration has been described in which the semiconductor forming the radiation detection element 1 is Si. However, the radiation detection element 1 may be configured using a semiconductor other than Si. In Embodiments 1 to 3, a configuration has been described in which the first semiconductor layer 11 is made of an n-type semiconductor and the doping layer 12 and the second semiconductor layer 14 are made of p-type semiconductors. However, the radiation detection element 1 may have a configuration in which the first semiconductor layer 11 is made of a p-type semiconductor and the doping layer 12 and the second semiconductor layer 14 are made of n-type semiconductors. In Embodiments 1 to 3, a configuration has been described in which the radiation detection element 1 is a silicon drift type radiation detection element. However, the radiation detection element 1 may be an element other than the silicon drift type radiation detection element as long as this is a semiconductor-based element. Therefore, the radiation detector 2 may be a radiation detector other than an SDD.

In Embodiments 1 to 3, a configuration has been described in which the radiation detector 2 does not include a window having a window material. However, the radiation detector 2 may include a window having a window material. In Embodiments 1 to 3, a configuration has been described in which the radiation detector 2 includes the collimator 22. However, the radiation detector 2 may be configured not to include the collimator 22. In Embodiments 1 to 3, a configuration has been described in which the radiation detection element 1 is housed in the housing 25. However, the radiation detector 2 may be configured not to include the housing 25.

The present invention is not limited to the content of the above-described embodiments, and various changes can be made within the scope of the claims. That is, embodiments obtained by combining technical means appropriately changed within the scope of the claims are also included in the technical scope of the present invention.

The features described in the respective embodiments can be combined with each other. In addition, the independent claims and the dependent claims described in the claims can be combined with each other in all combinations, regardless of the citation form. In addition, although the form of multiple claims that cite two or more other claims (multi-claim form) is used in the scope of claims, the present invention is not limited thereto. A form of multi-claim that cites at least one multi-claim (multi-multi claim) can also be used.

### Reference Signs List

- 100: radiation detection apparatus
- 1: radiation detection element
- 11: first semiconductor layer
- 12: doping layer
- 13: oxide layer
- 14: second semiconductor layer
- 15: signal output electrode
- 151: curved electrode
- 17: conductive layer
- 2: radiation detector
- 21: preamplifier
- 22: collimator
- 23: circuit board
- 25: housing
- 251: opening
- 4: irradiation unit
- 6: sample

## Claims

1. A method for manufacturing a radiation detection element, **characterized by** comprising:
forming an oxide layer made of a semiconductor oxide on a first semiconductor layer;
forming a second semiconductor layer on the oxide layer; and
implanting ions of a dopant, which is for changing the semiconductor forming the first semiconductor layer into a different type of semiconductor, into the first semiconductor layer through the second semiconductor layer and the oxide layer to form a doping layer made of a semiconductor doped with the dopant between the first semiconductor layer and the oxide layer.

2. The method for manufacturing a radiation detection element according to claim 1, **characterized by** further comprising:
reducing a thickness of the second semiconductor layer after forming the doping layer.

3. The method for manufacturing a radiation detection element according to claim 1 or 2, **characterized by** further comprising:
forming a conductive layer on the second semiconductor layer.

4. The method for manufacturing a radiation detection element according to claim 1, **characterized by** further comprising:
after forming the doping layer, removing the second semiconductor layer and forming a conductive layer on the oxide layer.

5. The method for manufacturing a radiation detection element according to any one of claims 1 to 4, **characterized by** further comprising:
thermally oxidizing the first semiconductor layer to form the oxide layer;
removing a part of the oxide layer; and
thermally oxidizing the first semiconductor layer after removing the part of the oxide layer to re-form the oxide layer in the removed portion of the oxide layer.

6. A radiation detection element, **characterized by** comprising:
a first semiconductor layer into which radiation to be detected enters;
a doping layer that is provided on a surface of the first semiconductor layer on a side on which the radiation is incident and that is made of a semiconductor doped with a dopant for changing a semiconductor forming the first semiconductor layer into a different type of semiconductor;
an oxide layer provided on the doping layer and made of a semiconductor oxide; and
a second semiconductor layer provided on the oxide layer.

7. The radiation detection element according to claim 6, **characterized in that**
the semiconductor forming the first semiconductor layer is n-type,
the dopant is boron, and
the semiconductor forming the second semiconductor layer is p-type.

8. The radiation detection element according to claim 6 or 7, **characterized in that**
the second semiconductor layer is made of polysilicon.

9. The radiation detection element according to any one of claims 6 to 8, **characterized by** further comprising:
a conductive layer provided on the second semiconductor layer.

10. A radiation detection element, **characterized by** comprising:
a first semiconductor layer into which radiation to be detected enters;
a doping layer that is provided on a surface of the first semiconductor layer on a side on which the radiation is incident and that is made of a semiconductor doped with a dopant for changing a semiconductor forming the first semiconductor layer into a different type of semiconductor;
an oxide layer provided on the doping layer and made of a semiconductor oxide; and
a conductive layer provided on the oxide layer,
wherein a thickness of the oxide layer is less than 50 nm, and
a concentration of the dopant contained in the doping layer is 1 × 10¹⁸ atoms/cm³ or less at a position where a depth from an interface between the oxide layer and the doping layer is 60 nm.

11. The radiation detection element according to any one of claims 6 to 10, **characterized by** further comprising:
a signal output electrode that is provided on a surface of the first semiconductor layer opposite to the surface on which the doping layer is provided and that outputs a signal in response to incidence of radiation; and
a plurality of curved electrodes which are arranged at positions surrounding the signal output electrode and are located at different distances from the signal output electrode and to which voltages are applied so that potentials change according to the distances from the signal output electrode.

12. A radiation detector, **characterized by** comprising:
the radiation detection element according to any one of claims 6 to 11;
a circuit board on which the radiation detection element is mounted;
a collimator that shields a part of radiation before the radiation is incident on the radiation detection element; and
a housing that accommodates the radiation detection element, the circuit board, and the collimator,
wherein the housing has an unblocked opening,
the radiation detection element is arranged so that an incidence surface on which radiation is incident faces the opening, and
the collimator is arranged between the radiation detection element and the opening.
